Europäisches Patentamt

European Patent Office

Office européen des brevets

(19)

(11) **EP 0 622 634 B1**

(12) # EUROPEAN PATENT SPECIFICATION

(45) Date of publication and mention
of the grant of the patent:
**21.10.1998  Bulletin 1998/43**

(51) Int Cl.$^6$: **G01P 15/09**, G11C 27/02

(21) Application number: **94105442.1**

(22) Date of filing: **08.04.1994**

(54) **A device for detecting detonation in an internal combustion engine**

**Vorrichtung zur Feststellung des Klopfens bei einem Verbrennungsmotor**

**Dispositif de détection de cognage dans un moteur à combustion interne**

(84) Designated Contracting States:
**DE FR GB**

(30) Priority: **28.04.1993 IT TO930293**

(43) Date of publication of application:
**02.11.1994  Bulletin 1994/44**

(73) Proprietor: **MAGNETI MARELLI S.p.A.**
**20145 Milano (IT)**

(72) Inventors:
• **Cagnoni, Michele**
**I-10135 Torino (IT)**

• **Diaco, Marco**
**I-10060 Bricherasio (Torino) (IT)**

(74) Representative: **Quinterno, Giuseppe et al**
**c/o JACOBACCI & PERANI S.p.A.**
**Corso Regio Parco, 27**
**10152 Torino (IT)**

(56) References cited:
**EP-A- 0 374 870**        **DE-A- 3 916 023**
**GB-A- 1 442 655**        **US-A- 3 665 172**
**US-A- 4 209 717**        **US-A- 4 816 713**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

The present invention relates in general to devices for the acquisition of a signal generated by a sensor, and more specifically relates to a circuit for recognition of the detonation in an internal combustion engine, comprising an input impedance adaptation circuit and a "sample and hold" circuit for storing the signal.

The use of accelerometric sensors for detecting the detonation in an internal combustion engine is known in the prior art. Such sensors provide an output voltage which, typically, must be acquired by a digital or analogue processing circuit. The processing circuit normally forms part of a central electronic processor within the engine compartment. It is therefore necessary to carry the voltage signal from the accelerometric sensor, naturally installed on the engine, to the central electronic processor.

A screened cable is used for this purpose because of the strong electromagnetic disturbances present in the engine compartment. Moreover, in prior art circuits use is typically made of an input impedance adaptation circuit and an acquisition and storage circuit, better known as a sample and hold circuit, to permit connection, for example, to an analogue-to-digital converter.

This arrangement has, however, certain disadvantages. The screened cable used to carry the signal from the sensor to the circuit has a parasitic capacitance with respect to ground, which causes degradation of the signal emitted by the accelorimetric sensor. This parasitic capacitance is, moreover, dependent on the length of the cable and is therefore difficult to compensate.

In known prior art circuits it is moreover necessary to maintain the output signal to permit acquisition of the signal itself by the analogue-to-digital converter.

US-A-4 816 713 relates to a device for measuring dynamic entities, such as a vibration or an acceleration, comprising a sensor of piezoelectric type connected to a FET amplifier of unitary gain. In particular, the sensor includes two piezoelectric crystals sandwiched and compressed between an external electrode of a U-shaped construction and an internal electrode, which are connected to the source and the gate of the FET for cancelling the effect of the capacitance of the piezoelectric elements which reduces the effective voltage gain. This device is specifically designed for piezoelectric crystals and can operate correctly only if the capacitance of the connections is small with respect to the capacitance of the crystals.

GB-A-1 442 655 relates to an amplifying system comprising a coaxial transmission cable for supplying an input signal to a negative input of an amplifier, and in which the positive input of the amplifier and the sheath of the cable are directly earthed. A feedback impedance between an output and the input of the amplifier is adjusted to provide an input impedance equal to the characteristic impedance of the cable so as to match the impedance of the amplifier with that of the cable without using a matching resistance, in view of a reduction of the noise.

The object of the present invention is to provide an improved circuit which makes it possible to resolve the above indicated disadvantages in a satisfactory manner.

According to the present invention this object is achieved by a device having the characteristics set out specifically in the appended Claim 1.

Further advantages and characteristics of the present invention will become apparent from the following detailed description, made with the aid of the attached drawings, provided purely by way of non-limitative example, in which:

Figure 1 is a block schematic representation of the device according to the present invention;

Figure 2 is a schematic representation of the circuit of the device of Figure 1;

Figure 3 is a schematic representation of a circuit equivalent to the circuit represented in Figure 2; and

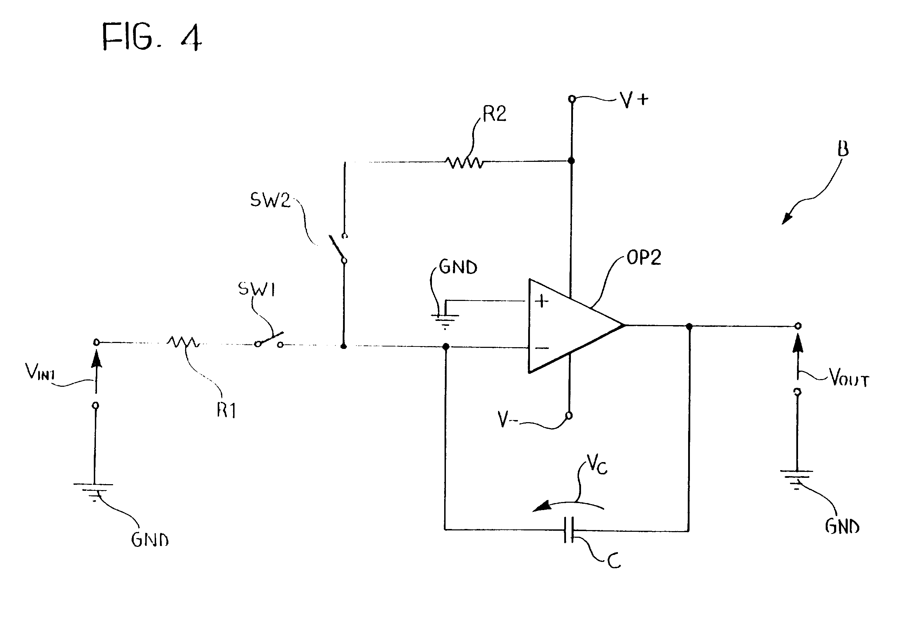

Figure 4 is a schematic representation of a further circuit of the device of Figure 1.

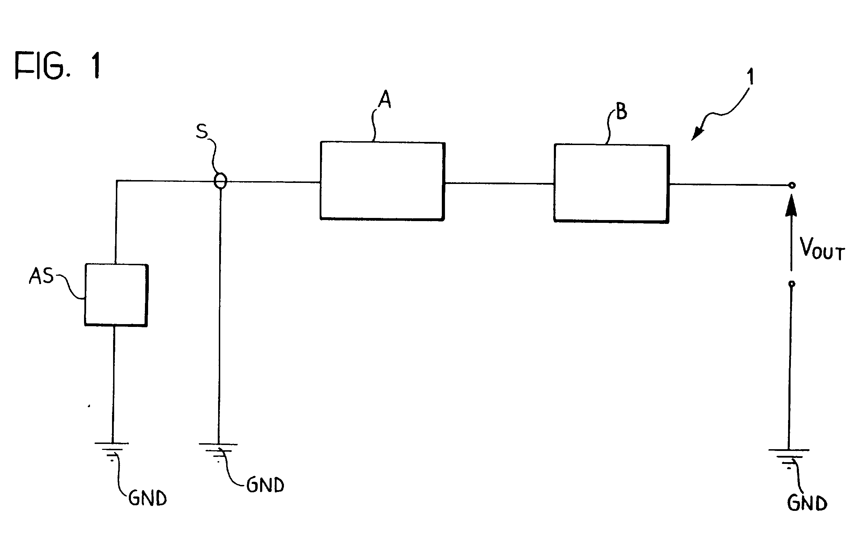

With reference to Figure 1, a device comprising an accelerometric sensor AS installed on an internal combustion engine is generally indicated with reference numeral 1. The sensor AS is connected to an impedance adaptation circuit A (first stage) by means of a conductor provided with a screen S connected to ground GND of the electrical installation. The impedance adaptation circuit A is in turn connected in series with the sample and hold circuit B (second stage).

The output $V_{out}$ of the sample and hold circuit B, which is also the output of the device 1 according to the invention, is available for a processing circuit (not illustrated). For example, in the case of a digital processing circuit the output $V_{out}$ is connected to an analogue-to-digital converter (not illustrated).

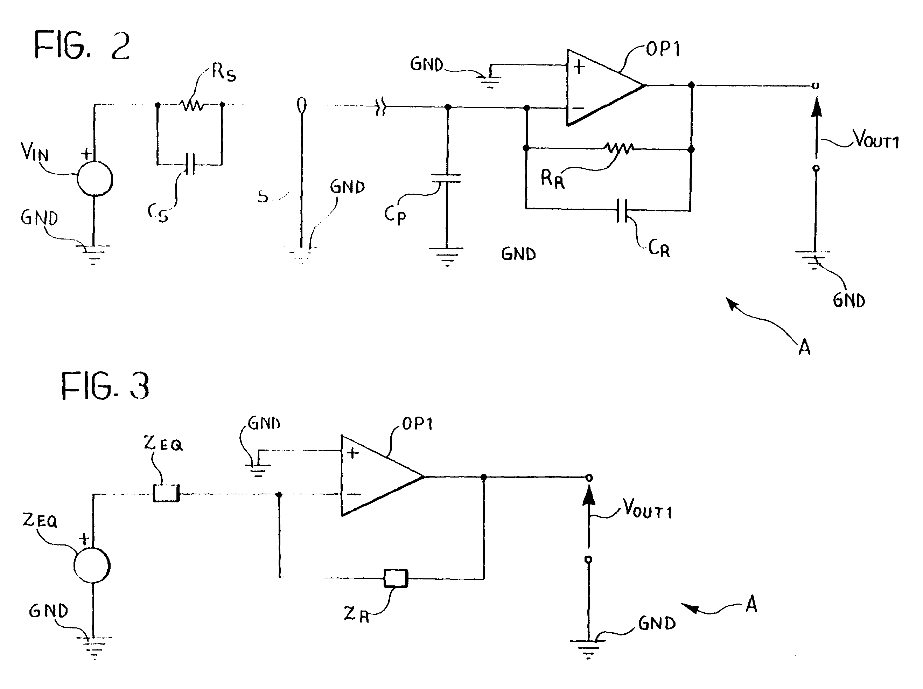

With reference to Figure 2 the first stage A of the device according to the present invention will now be described. The accelerometric sensor AS is represented in this case as a voltage generator $V_{in}$ connected to a cable for transmission of the signal, provided with a screen S connected to ground GND. Naturally the accelerometric sensor AS is not an ideal component and therefore in order to be able to model it in a realistic manner in the circuit it is represented as a series impedance composed of a series resistance $R_s$ in parallel with a series compacitence $C_s$.

The input impedance adaptation circuit A is constituted substantially by an operational amplifier OP1 configured as an inverting amplifier and having a feedback impedance $R_r$, $C_r$ the value of which is equal to the series impedance $R_s$, $C_s$ of the accelerometric sensor AS used. The input impedance of the operational amplifier OP1 is constituted by the impedance $R_s$, $C_s$ of the accelerometric sensor AS itself.

It can be demonstrated mathematically that the amplitude of the output signal $V_{out1}$ does not depend on a parasitic capacitance $C_p$ introduced by the connection cabling between the accelerometric sensor AS and the circuit A.

The demonstration will be conducted with the aid of Figure 3 in which the circuit of Figure 2 is represented in simplified form, that is to say with the passive components regrouped in the input impedance $Z_{eq}$ and feedback impedance $Z_r$. With the gain of the operational amplifier OP1 in the inverting configuration defined as G' one has :

$$G' = V_{out1} / V_{eq} = - Z_r / Z_{eq}$$

where:

$$Z_1 = (R_s / SC_s) / (R_s + 1/SC_s)$$

$$Z_r = (R_r / SC_r) / (R_r + 1/SC_r)$$

$$V_{eq} = V_{in} (1/SC_p) / (Z_1 + 1/SC_p)$$

$$Z_{eq} = (Z_1 / SC_p) / (Z_1 + 1/SC_p)$$

one can therefore see that the gain G' is given by

$$G' = V_{out1} / (V_{in} \frac{1/SC_p}{Z_1 + 1/SC_p}) = - \frac{Z_r}{(Z_1 / SC_p) / (Z_1 + 1/SC_p)}$$

At this point we can pass to the calculation of the gain G' of the first stage A of the device, which is given by the following formula:

$$G = \frac{V_{out1}}{V_{in}} = - \frac{Z_r}{(Z_1/SC_p) / (Z_1 + 1/SC_p)} \frac{Z_1 + 1/SC_p}{1/SC_p}$$

which simplifies to give the following formula:

$$G = \frac{V_{out1}}{V_{in}} = - \frac{Z_r}{Z_1}$$

As can be seen the component given by the parasitic capacitance $C_p$ does not enter the formula which defines the gain G of the circuit A. The operation of the input impedance adaptation circuit A is therefore independent of the parasitic capacitance $C_p$.

Because of this characteristic the installation of the sensor AS is, moreover, much simpler since it is not necessary to worry about the length of the cabling.

The second stage B, connected in series to the first stage A, is a sample and hold circuit essentially constituted by an operational amplifier OP2 to which signals are applied at one input and which is connected in inverting integrator configuration.

The circuit includes two solid state switches SW1, SW2, for example formed in MOS technology. The two switches SW1, SW2 are normally open. When closed the first switch SW1 enables charging of the capacitor C of the integrator to the input voltage $V_{in1}$ via a resistor R1. Consequently the output voltage $V_{out}$ increases. The slope with which the

output voltage $V_{out}$ increases depends in an inversely proportional manner on the input signal $V_{in1}$. The input signal $V_{in1}$ is naturally the voltage $V_{out1}$ at the output from the first stage A.

When the first switch SW1 is open the integrator remains in the state reached at the instant of opening for an indeterminate time. In this period acquisition of the output voltage $V_{out}$ by an analogue-to-digital converter can take place. Once this operation terminates the integrator is prepared for a new acquisition by taking the inverting input of the operational amplifier OP2 to an electric potential greater than that of the non inverting input by closure of the second switch SW2. The switch SW2 is in fact connected, via a resistor R2, to the positive supply terminal V+.

The operation of the integrator circuit follows a classic pattern in which, when the switch SW1 is closed and the switch SW2 is open, the output voltage $V_{out}$ is given by the following equation:

$$V_{out} = - (1/RC) \int_{-\infty}^{t} V_{in}(r)\,dr$$

Naturally, when both the switches SW1, SW2 are open the output voltage is constant and one has:

$$V_{out} = - V_c$$

Upon resetting of the integrator, that is with the switch SW1 open and the switch SW2 closed, the output voltage $V_{out}$ is:

$$V_{out} = V-$$

Where V- is the voltage of the negative supply terminal V-, that is to say the voltage opposite the positive supply terminal V+.

This circuit configuration makes it possible to obtain a sample and hold circuit and the associated resetting function without adding another operational amplifier as would, on the other hand, be necessary with a conventional arrangement.

Moreover, the sample and hold circuit B according to the invention permits acquisition without delay by the analogue-to-digital converter and an improvement in the management of the output signal by the processor circuit.

Naturally, the principle of the invention remaining the same, the details of construction and the embodiments can be widely varied with respect to what has been described and illustrated, for example by utilising the circuit described for detection of different phenomena from detonation in an internal combustion engine (also by means of sensors other than of accelerometric type) without by this departing from the ambit of the present invention.

## Claims

1. A device for detecting a physical quantity, capable of being connected to processor means operable to acquire a signal ($V_{out}$) indicative of the said quantity, comprising:

   - sensor means (AS) having a series impedance ($Z_{eq}$) and operable to generate at its output a first electric voltage ($V_{in}$), indicative of the said quantity,
   - impedance adaptation means (A) having an input connected to the output of the said sensor means (AS) and operable to generate at its output a second voltage ($V_{out1}$, $V_{in1}$) proportional to the said first voltage ($V_{in}$),
   - acquisition and memorisation means (B) operable to acquire, in predetermined short time intervals, the value of the said second voltage ($V_{out1}$, $V_{in1}$) and to memorise it,

   characterised in that

   the said impedance adaptation means (A) include first inverting amplifier means (OP1, $Z_r$) comprising a high gain operational amplifier (OP1) and a feedback impedance ($Z_r$) comprising a resistor ($R_r$) and a first capacitor

($C_r$) and substantially equal to the said series impedance ($Z_{eq}$) of the sensor means (AS); and in that the said acquisition and memorisation means (B) include integrator means (OP2, C) comprising a second operational amplifier (OP2) and a second capacitor (C) configured to operate as an inverting integrator.

**2.** A device according to claim 1, characterised in that the said first capacitor ($C_r$) has a capacitance substantially equal to the series capacitance ($C_s$) of the said impedance ($Z_{eq}$) of the sensor means (AS).

**3.** A device according to claim 2, characterised in that the said resistor ($R_r$) has a resistance substantially equal to the series resistance ($R_s$) of the said series impedance ($Z_{eq}$) of the sensor means (AS).

**4.** A device according to any preceding claim, characterised in that the said acquisition and memorisation means (B) comprise first switch means (SW1) capable of:

- connecting the said output ($V_{out1}$, $V_{in1}$) of the said impedance adaptation means (A) to the said second capacitor (C), in the said predetermined short time intervals, in a first operating condition, in such a way that the said second capacitor (C), and consequently one output of the said device, is taken to the voltage ($V_{out}$) indicative of the voltage at the output of the said impedance adaptation means (A),
- disconnecting the said output of the said impedance adaptation means (A) from the said second capacitor (C), in a second operating condition, in such a way that the said voltage ($V_{out}$) at the output of the device is maintained substantially stable in predetermined time periods lying between the said predetermined short time intervals.

**5.** A device according to claim 4, characterised in that the said acquisition and memorisation means (B) include second switch means (SW2) capable of connecting the said second capacitor (C) to a predetermined voltage (V+), at the end of the said predetermined time periods in order to carry the said second capacitor (C) to a predetermined voltage.

**6.** A device according to claim 4 and claim 5, characterised in that the said first and second switch means (SW1, SW2) are semi-conductor devices.

**7.** A device according to any preceding claim, characterised in that the said sensor means (AS) comprise an accelerometric sensor.

**8.** A device according to claim 7, characterised in that it is operable to allow the detection of the phenomenon of detonation in an internal combustion engine.


**Patentansprüche**

**1.** Vorrichtung zum Abtasten einer physikalischen Größe, wobei die Vorrichtung mit einer Prozessorstufe verbunden werden kann, die in Betrieb steht, um ein Signal ($V_{out}$) zu erfassen, das diese Größe kennzeichnet, wobei die Vorrichtung enthält:

- eine Fühlereinrichtung (AS), die eine Serienimpedanz ($Z_{eq}$) besitzt und in Betrieb steht, um an ihrem Ausgang eine erste elektrische Spannung ($V_{in}$) zu erzeugen, die diese Größe kennzeichnet;
- eine Impedanzanpassungsstufe (A), die einen Eingang besitzt, der mit dem Ausgang der Fühlereinrichtung (AS) verbunden ist und die in Betrieb steht, um an ihrem Ausgang eine zweite Spannung ($V_{out1}$, $V_{in1}$) zu erzeugen, die proportional der ersten Spannung ($V_{in}$) ist,
- eine Erfassungs- und Speicherstufe (B), die in Betrieb steht, um in vorgegebenen kurzen Zeitintervallen den Wert der zweiten Spannung ($V_{out1}$, $V_{in1}$) zu erfassen und zu speichern; dadurch gekennzeichnet,

daß die Impedanzanpassungsstufe (A) eine erste invertierende Verstärkerstufe (OP1, $Z_r$) aufweist, die einen Operationsverstärker mit hohem Verstärkungsfaktor (OP1) sowie eine Rückkopplungsimpedanz ($Z_r$) enthält, die aus einem Widerstand ($R_r$) und einem ersten Kondensator ($C_r$) besteht und im wesentlichen gleich der Serienimpedanz ($Z_{eq}$) der Fühlereinrichtung (AS) ist; und daß die Erfassungs- und Speicherstufe (B) eine Integratorstufe (OP2, C) aufweist, die einen zweiten Operationsverstärker (OP2) sowie einen zweiten Kondensator (C) enthält, wobei sie so aufgebaut ist, daß sie als invertierender Integrator arbeitet.

**2.** Vorrichtung gemäß Anspruch 1, dadurch gekennzeichnet, daß der erste Kondensator ($C_r$) einen Kapazitätswert besitzt, der im wesentlichen gleich der Serienkapazität ($C_s$) der Impedanz ($Z_{eq}$) der Fühlereinrichtung (AS) ist.

**3.** Vorrichtung gemäß Anspruch 2, dadurch gekennzeichnet, daß der Widerstand ($R_r$) einen Widerstandswert besitzt, der im wesentlichen gleich dem Serienwiderstand ($R_s$) der Serienimpedanz ($Z_{eq}$) der Fühlereinrichtung (AS) ist.

**4.** Vorrichtung gemäß irgendeinem der bisherigen Ansprüche, dadurch gekennzeichnet, daß die Erfassungs- und Speicherstufe (B) eine erste Schalterstufe (SW1) aufweist, die dazu dient, um:

- den Ausgang ($V_{out1}$, $V_{in1}$) der Impedanzanpassungsstufe (A) mit dem zweiten Kondensator (C) innerhalb der vorgegebenen kurzen Zeitintervalle in einem ersten Betriebszustand so zu verbinden, daß der zweite Kondensator (C) und damit ein Ausgang der Vorrichtung an der Spannung ($V_{out}$) liegt, die die Spannung am Ausgang der Impedanzanpassungsstufe (A) kennzeichnet;
- den Ausgang der Impedanzanpassungsstufe (A) vom zweiten Kondensator (C) in einem zweiten Betriebszustand so zu trennen, daß die Spannung ($V_{out}$) am Ausgang der Vorrichtung in vorgegebenen Zeitintervallen im wesentlichen stabil gehalten wird, die zwischen den vorgegebenen kurzen Zeitintervallen liegen.

**5.** Vorrichtung gemäß Anspruch 4, dadurch gekennzeichnet, daß die Erfassungs- und Speicherstufe (B) eine zweite Schalterstufe (SW2) aufweist, die dazu dient, um den zweiten Kondensator (C) am Ende der vorgegebenen Zeitintervalle an eine vorgegebene Spannung (V+) zu legen, um den zweiten Kondensator (C) auf eine vorgegebene Spannung zu bringen.

**6.** Vorrichtung gemäß Anspruch 4 und 5, dadurch gekennzeichnet, daß die erste und zweite Schalterstufe (SW1, SW2) Halbleiterelemente sind.

**7.** Vorrichtung gemäß irgendeinem der bisherigen Ansprüche, dadurch gekennzeichnet, daß die Fühlereinrichtung (AS) einen Beschleunigungs-Meßfühler enthält.

**8.** Vorrichtung gemäß Anspruch 7, dadurch gekennzeichnet, daß die Vorrichtung in Betrieb steht, um die Erscheinung einer Detonation in einem Verbrennungsmotor abtasten zu können.

## Revendications

**1.** Dispositif pour détecter une quantité physique, pouvant être connecté à des moyens formant processeur utilisables pour acquérir un signal ($V_{out}$) indicatif de ladite quantité, comportant:

- des moyens (AS) formant capteur ayant une impédance série ($Z_{eq}$) et utilisables pour générer au niveau de leur sortie une première tension électrique ($V_{in}$), indicative de ladite quantité,

- des moyens d'adaptation d'impédance (A) ayant une entrée connectée à la sortie desdits moyens (AS) formant capteur et utilisables pour générer au niveau de leur sortie une seconde tension ($V_{out1}$, $V_{in1}$) proportionnelle à ladite première tension ($V_{in}$),

- des moyens d'acquisition et de mémorisation (B) utilisables pour acquérir, pendant des intervalles de temps courts prédéterminés, la valeur de ladite seconde tension ($V_{out1}$, $V_{in1}$) et pour la mémoriser, caractérisé en ce que

lesdits moyens d'adaptation d'impédance (A) comportent des premiers moyens (OP1, $Z_r$) formant amplificateur inverseur comportant un amplificateur opérationnel à gain élevé (OP1) et une impédance de retour ($Z_r$) constituée d'une résistance ($R_r$) et d'un premier condensateur ($C_r$) et qui est pratiquement égale à ladite impédance série ($Z_{eq}$) des moyens (AS) formant capteur, et en ce que

lesdits moyens d'acquisition et de mémorisation (B) comportent des moyens (OP2, C) formant intégrateur constitués d'un second amplificateur opérationnel (OP2) et d'un second condensateur (C), configurés de manière à fonctionner comme un intégrateur inverseur.

**2.** Dispositif selon la revendication 1, caractérisé en ce que ledit premier condensateur ($C_r$) a une capacité qui est à peu près égale à la capacité série ($C_s$) de ladite impédance ($Z_{eq}$) des moyens (AS) formant capteur.

3. Dispositif selon la revendication 2, caractérisé en ce que ladite résistance ($R_r$) a une résistance qui est à peu près égale à la résistance série ($R_s$) de ladite impédance série ($Z_{eq}$) des moyens (AS) formant capteur.

4. Dispositif selon l'une quelconque des revendications précédentes, caractérisé en ce que lesdits moyens d'acquisition et de mémorisation (B) comportent des premiers moyens de commutation (SW1) capables de:

   - connecter ladite sortie ($V_{out1}$, $V_{in1}$) desdits moyens d'adaptation d'impédance (A) audit second condensateur (C), pendant lesdits intervalles de temps courts prédéterminés, dans un premier état opératoire, de manière à ce que ledit second condensateur (C), et en conséquence une première sortie dudit dispositif, prenne la tension ($V_{out}$) indicative de la tension obtenue à la sortie desdits moyens d'adaptation d'impédance (A),

   - déconnecter ladite sortie desdits moyens d'adaptation d'impédance (A) dudit second condensateur (C), dans un second état opératoire, de manière à ce que ladite tension ($V_{out}$), obtenue à la sortie du dispositif, soit maintenue à un niveau pratiquement stable pendant des périodes de temps prédéterminées se trouvant entre lesdits intervalles de temps courts prédéterminés.

5. Dispositif selon la revendication 4, caractérisé en ce que lesdits moyens d'acquisition et de mémorisation (B) comportent des seconds moyens de commutation (SW2) capables de connecter ledit second condensateur (C) à une tension prédéterminée (V+), à la fin desdites périodes de temps prédéterminées, pour amener ledit second condensateur (C) à une tension prédéterminée.

6. Dispositif selon les revendications 4 et 5, caractérisé en ce que lesdits premiers et seconds moyens de commutation (SW1, SW2) sont des dispositifs à semi-conducteurs.

7. Dispositif selon l'une quelconque des revendications précédentes, caractérisé en ce que lesdits moyens (AS) formant capteur comprennent un capteur accélérométrique.

8. Dispositif selon la revendication 7, caractérisé en ce qu'il est utilisable pour permettre de détecter le phénomène de détonation dans un moteur à combustion interne.

FIG. 1

EP 0 622 634 B1

# FIG. 2

# FIG. 3

FIG. 4

EP 0 622 634 B1

R2

V+

B

SW2

SW1

GND

OP2

+

−

V−

V_IN1

R1

GND

V_OUT

V_C

C

GND